## Europäisches Patentamt
## European Patent Office
## Office européen des brevets

(11) Publication number: **0 022 271**
**B1**

(12)

# EUROPEAN PATENT SPECIFICATION

(45) Date of publication of patent specification: **09.01.85**

(21) Application number: **80103857.1**

(22) Date of filing: **07.07.80**

(51) Int. Cl.⁴: **C 08 L 49/00,** C 08 J 3/20 //
C08K3/10, C08K5/08,
C08K5/09, H01B1/00

(54) **Doped polyacetylenes and their production.**

(30) Priority: **10.07.79 JP 86402/79**
**10.07.79 JP 86403/79**
**28.08.79 JP 108641/79**

(43) Date of publication of application:
**14.01.81 Bulletin 81/02**

(45) Publication of the grant of the patent:
**09.01.85 Bulletin 85/02**

(84) Designated Contracting States:
**DE GB**

(56) References cited:
**US-A-2 351 108**
**US-A-3 926 907**

(73) Proprietor: **JAPAN SYNTHETIC RUBBER CO.,
LTD.**
**11-24, Tsukiji-2-chome Chuo-ku
Tokyo (JP)**

(72) Inventor: **Matsumura, Yoshio
14-30, Tsukimino-8-chome
Yamato-shi (JP)**
Inventor: **Nozue, Ikuo
29, Aobadai-2-chome
Midori-ku, Yokohama (JP)**
Inventor: **Ukachi, Takashi
29, Aobadai-2-chome
Midori-ku, Yokohama (JP)**

(74) Representative: **Patentanwälte Beetz sen. -
Beetz jun. Timpe - Siegfried - Schmitt-Fumian
Steinsdorfstrasse 10
D-8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to doped acetylene polymers (polyacetylenes) and a process for producing them.

Polyacetylenes are insulators or semiconductors having an electrical conductivity in the order of $10^{-5}$ to $10^{-9} \Omega^{-1} \cdot cm^{-1}$ [See Makromol. Chem. *175* (1978) 1565]. Heretofore, several methods have been proposed to improve the electrical conductivity of this polymer. For instance, J. Amer. Chem. Soc. *100* (1978) 1013 discloses a process for increasing the electrical conductivity of polyacetylenes by doping it in the form of a film with a HBr, $Cl_2$, $Br_2$, $I_2$, ICl, IBr, $AsF_5$ or Na as a dopant. The most effective dopants among them are $I_2$ and $AsF_5$, and the highest electrical conductivity obtained by this method is in the order of $10^2 \Omega^{-1} \cdot cm^{-1}$. A process for doping with a silver salt such as $AgBF_4$ or $AgClO_4$ or $FSO_2OOSO_2F$ is known from J. Chem. Soc. Chem. Comm. (1978) 489 and 1066. In the former case an electrical conductivity in the order of $10^0 \Omega^{-1} \cdot cm^{-1}$ can be attained, and in the latter case, an electrical conductivity in the order of $10^2 \Omega^{-1} \cdot cm^{-1}$ can be obtained. The doping with these chemicals is carried out by allowing the chemicals in the gaseous state or in the form of a solution in a solvent to permeate into the polyacetylene, because the acetylene polymer is insoluble in the chemicals.

The present inventors have made an intensive survey of a process for doping polyacetylenes and have consequently found that polyacetylenes can be doped with platinum group metal complexes, carbonium salts, oxonium salts and parabenzoquinone compounds.

It is an object of this invention to provide novel doped polyacetylenes and a novel process for producing them.

According to this invention, there are provided polyacetylenes doped with a platinum group metal complex, a carbonium salt, an oxonium salt or a parabenzoquinone compound.

The doped polyacetylenes of this invention can be prepared by immersing a polyacetylene under an inert gas atmosphere in an organic solvent solution of a platinum group metal complex, carbonium salt, oxonium salt or parabenzoquinone compound.

The process of this invention has the following characteristic advantages, and in view of these advantages, this invention is widely applicable and very valuable from the commercial point of view:

1. The dopant used in this invention is free from corrosiveness and volatility. This is very advantageous for the doping operation, and in addition, the doped polyacetylene obtained has a stable performance.
2. According to the process of this invention, the electrical conductivity of the objective doped polyacetylenes can be regulated to any desired order of magnitude.
3. The doped polyacetylenes obtained by the process of this invention have excellent performance as organic semiconductors for solar batteries and various sensors.
4. In particular, the polyacetylenes doped with a platinum group metal complex, a carbonium salt or an oxonium salt are excellent in heat-resistance and light-stability under an inert atmosphere or under vacuum.

The platinum group metal complex used in this invention is a platinum group metal complex which is active for substitution reactions with olefines and includes, for example,

$(PhCN)_2PdCl_2$, $(COD)PdCl_2$, $[(C_2H_4)PdCl_2]_2$, $(Ph_4C_4)PdCl_2$, $(COD)PtCl_2$, $K[PtCl_3(C_2H_4)]H_2O$, $[Pt(C_2H_4)Cl_2]_2$, $(PhCN)_2PtCl_2$, $[(C_2H_4)_2RhCl]_2$ and $Ru(COD)Cl_2$,

wherein COD stands for 1,5-cyclooctadiene and $Ph_4C_4$ for tetraphenylcyclobutadiene. Palladium complexes such as $(PhCN)_2PdCl_2$ and $[(C_2H_4)PdCl_2]_2$ are preferred as the platinum group metal complex used in this invention.

Examples of the carbonium salt and oxonium salt used in this invention include onium salts consisting of combinations of the following cations and anions:

Cations:
triphenylmethyl ion $[(C_6H_5)_3C]^+$,
tropylium ion $(C_7H_7^+)$,
acyl ion $(RCO^+)$,
dialkoxycarbonium ion $[RC(OR')(OR'')]^+$,
triethyloxonium ion $[(C_2H_5)_3O]^+$.

In the above formulae, R, R' and R'' represent independently an organic group and usually alkyls, aryls or aralkyls, and R, R' and R'' may be the same or different.

Anions:
$BF_4^-$, $AlCl_4^-$, $FeCl_4^-$, $SnCl_5^-$, $PF_6^-$, $PCl_6^-$, $SbCl_6^-$, $SbF_6^-$, $ClO_4^-$, $CF_3SO_3^-$, $CF_3CO_2^-$.

Preferable cations are triphenylmethyl ion and triethyloxonium ion, and preferable anions are $BF_4^-$ and $ClO_4^-$.

Parabenzoquinone compounds used in this invention include, for example, 2,3-dicyano-5-chloro-parabenzoquinone, 2,3-dichloro-5,6-dicyanoparabenzoquinone, 2,3-dicyano-5-phenylsulphonylpara-benzoquinone, 2,3-dicyano-5-chloro-6-phenylsulfonylparabenzoquinone and 2,3,5,6-tetracyanoparabenzoquinone. Preferable parabenzoquinone compounds are those having a first half wave reduction potential (−E 1/2) of less than −0,2 V at 25°C as measured with a saturated calomel electrode using $LiClO_4$ as a supporting electrolyte in acetonitrile. The most preferred parabenzoquinone compound is 2,3-dichloro-5,6-dicyanoparabenzoquinone. The first half wave reduction potential of parabenzoquinone compounds is described in, for example, The Chemistry of the Quinoid Compounds, Part 2, John Wiley and Sons (1974), p. 770.

As the organic solvents used in this invention, any kind of organic solvent may be used, as far as the solvent can dissolve the above-mentioned platinum group metal complex, carbonium salt, oxonium salt or parabenzoquinone derivative.

As the solvent, there may be mentioned, for example, aromatic hydrocarbons such as benzene, toluene and xylene, nitro compounds such as nitromethane, nitroethane, and nitrobenzene, nitrile compounds such as acetonitrile and benzonitrile, ether compounds such as diethyl ether, tetrahydrofuran, dioxane and anisole, lower alcohols such as methanol, ethanol, and propanol, halogeno compounds such as dichloromethane, chloroform, chlorobenzene, methylene chloride and trifluoroacetic acid, ester compounds such as methyl acetate, and ethyl acetate, ketone compounds such as acetophenone, and acetone, sulfoxide compounds such as dimethylsulfoxide, amide compounds such as N,N-dimethylformamide and lower organic acids such as acetic acid and their anhydrides such as acetic anhydride.

The form of the starting polyacetylene used is not critical; it may be a powder, film or fibers. The doping treatment is preferably conducted under an inert gas atmosphere, since the polyacetylene is unstable against oxygen. For instance, the doping is carried out by immersing the polyacetylene in an organic solvent solution of a platinum group metal complex, a carbonium salt, an oxonium salt or a parabenzoquinone compound. The concentration of the solution used for doping is decided depending upon the solubility of the dopant used because the solubility of the dopant depends on the kind of the dopant used. However, there is the tendency that the higher the concentration used, the larger the weight increase of the polymer doped in a short period of time becomes. The period of immersing the polyacetylene may be varied depending upon the concentration of the solution used and the temperature for the doping treatment. The immersion temperature is not critical and the immersion treatment may be effected at any temperature at which the dopant does not decompose and the solvent does not solidify. Generally, the immersion is effected at 10° to 70°C.

The doped polyacetylene thus prepared is subjected to measurement of its electrical conductivity by a 4-probe method. The electrical conductivity of the doped polymer varies depending on the kind of dopant and the weight increase of the doped polyacetylene. The larger the weight increase of the doped polyacetylene, the greater the electrical conductivity of the doped acetylene polymer becomes. Therefore, the electrical conductivity of the doped polyacetylene can be adjusted by controlling the weight increase of the doped polyacetylene.

Furthermore, the doped polyacetylene is also handled preferably under an inert gas atmosphere, since the obtained polymer is also unstable against oxygen.

The following examples illustrate the invention.

Preparation of polyacetylene

The polyacetylene used in the examples was prepared by the following method:

In a 500-ml glass vessel was placed 1,7 ml of titanium tetrabutoxide under a nitrogen atmosphere and was dissolved in 30 ml of toluene in the vessel. Thereto was added 2,7 ml of triethylaluminium with stirring to effect reaction. The vessel containing the reaction product was mounted on a polymerization apparatus, and the catalyst solution contained in the vessel was first degassed by solidifying by liquid nitrogen in the vessel, removing the nitrogen in the vessel by a vacuum pump, returning the temperature of the vessel to room temperature to vaporize the nitrogen dissolved in the solution and then solidifying the solution again by liquid nitrogen and evacuating. Thereafter, the vessel was kept at the temperature of a dry ice-methanol mixture and purified acetylene was introduced into the vessel under reduced pressure from a gas bomb.

Polymerization occurred at once on the surface of the solution and an acetylene polymer in the form of a film was formed. Thirty minutes after the introduction of acetylene, the vessel was taken out of the polymerization apparatus and nitrogen gas was introduced into the vessel. The catalyst solution was removed from the vessel by means of a syringe, and thereafter the polymer obtained was dried and washed thoroughly with deoxygenated toluene. The toluene was thereafter removed by means of a syringe, and the contents of the vessel were dried under vacuum to obtain a polyacetylene film.

The electrical conductivity of this polyacetylene film was measured by a 4-probe method was $10^{-8} \Omega^{-1} \cdot cm^{-1}$.

Example 1

A polyacetylene film was immersed into a solution of 0,2 g of $[(C_2H_4)PdCl_2]_2$ in 20 ml of dried deoxygenated chloroform and allowed to stand 24 h at room temperature. The polyacetylene film was thereafter transferred to another vessel, washed with chloroform and vacuum-dried.

The electrical conductivity of the doped polyacetylene film thus obtained was $3 \cdot 10^{-2}\Omega^{-1} \cdot cm^{-1}$. The doped polyacetylene film was subjected to the ESCA (Electron Spectroscopy for Chemical Analysis) measurement to detect only divalent Pd. From this fact, it was understood that the electrical conductivity of the doped polyacetylene was increased as a result of the doping with the Pd compound and the Pd metal deposited upon decomposition of the complex did not participate in the increase in electrical conductivity.

When the doped polyacetylene was allowed to stand for 6 months at 100°C at a reduced pressure of $1,33 \cdot 10^{-4}$ bar (0,1 Torr) or under natural weather conditions in a glass container at a reduced pressure of $1,33 \cdot 10^{-4}$ bar (0,1 Torr), substantially no change in electrical conductivity was observed.

It is to be noted that, in this example, all the procedures were carried out under a nitrogen atmosphere so as not to expose the polyacetylene to air; the same applies to the subsequent examples unless otherwise specified.

Example 2

A polyacetylene film was immersed into a solution of 0,1 g of $(PhCN)_2PdCl_2$ in 20 ml of dried deoxygenated methylene chloride and allowed to stand 24 h at room temperature. The polyacetylene film was then transferred to another vessel, washed with fresh methylene chloride and vacuum-dried. The doped polyacetylene film thus obtained had an electrical conductivity of $3 \cdot 10^{-3}\Omega^{-1} \cdot cm^{-1}$.

Example 3

A polyacetylene film was immersed into a solution of 0,1 g of $(PhCN)_2PtCl_2$ in 20 ml of dried deoxygenated methylene chloride and allowed to stand 24 h at room temperature. The polyacetylene film was then transferred to another vessel and washed with fresh methylene chloride and vacuum-dried. The electrical conductivity of the doped polyacetylene film thus obtained was $7 \cdot 10^{-5}\Omega^{-1} \cdot cm^{-1}$.

Example 4

A polyacetylene polymer film was immersed into a solution of 0,1 g of $[(C_2H_4)_2RhCl]_2$ in dried deoxygenated methylene chloride and allowed to stand 24 h at room temperature. The polyacetylene film was thereafter transferred to another vessel, washed with fresh methylene chloride and vacuum-dried.

The electrical conductivity of the doped polyacetylene film thus obtained was $5 \cdot 10^{-5}\Omega^{-1} \cdot cm^{-1}$.

Example 5

A polyacetylene film was immersed into a solution of 0,1 g of $Ru(COD)Cl_2$ in 20 ml of dried deoxygenated chloroform and allowed to stand 24 h at room temperature. The polyacetylene film was thereafter transferred to another vessel, washed with fresh chloroform and vacuum-dried.

The doped polyacetylene film thus obtained had an electrical conductivity of $6 \cdot 10^{-5}\Omega^{-1} \cdot cm^{-1}$.

Example 6

A polyacetylene film was immersed into a dried methylene chloride solution of $[(C_2H_5)_3O]^+BF_4^-$ (0,3 g/10 ml), subjected to deaeration and then allowed to stand 24 h at room temperature. The polyacetylene film was thereafter transferred to another vessel, washed with fresh methylene chloride and vacuum-dried. All the procedures were carried out under an argon atmosphere.

The doped polyacetylene film thus obtained had an electrical conductivity of $5 \cdot 10^{-2}\Omega^{-1} \cdot cm^{-1}$. When the doped polyacetylene was allowed to stand for 6 months at 100°C at a reduced pressure of $1,33 \cdot 10^{-4}$ bar (0,1 Torr) or under natural weather conditions in a glass container at a reduced pressure of $1,33 \cdot 10^{-4}$ bar (0,1 Torr), substantially no change in electrical conductivity was observed.

Example 7

A polyacetylene film was immersed into a dried methylene chloride solution of $[(C_6H_5)_3O]^+BF_4^-$ (0,3 g/10 ml), subjected to deaeration and allowed to stand 24 h at room temperature. The polyacetylene film was thereafter transferred to another vessel, washed with fresh methylene chloride and dried under vacuum. The doped polyacetylene film thus obtained had an electrical conductivity of $3 \cdot 10^{-1}\Omega^{-1} \cdot cm^{-1}$.

All the procedures were carried out under an argon atmosphere.

Example 8

In 20 ml of dried deoxygenated benzene was dissolved 0,1 g of 2,3-dichloro-5,6-dicyanopara-benzoquinone (−E 1/2=−0,5 V). A polyacetylene film was immersed into the solution and allowed to stand 24 h at room temperature. The polyacetylene film was thereafter transferred to another vessel

# 0 022 271

and vacuum-dried. The doped polyacetylene film thus obtained had an electrical conductivity of $2 \cdot 10^{-1} \Omega^{-1} \cdot cm^{-1}$.

### Example 9

In 20 ml of dried deoxygenated benzene was dissolved 0,1 g of 2,3-dicyano-5-chloroparabenzoquinone (—E 1/2=—0,41 V). A polyacetylene film was immersed in the solution and allowed to stand 24 h at room temperature. The polyacetylene film was then transferred to another vessel and vacuumdried. The doped acetylene polymer film thus obtained had an electrical conductivity of $5 \cdot 10^{-3} \Omega^{-1} \cdot cm^{-1}$.

### Example 10

A polyacetylene film was immersed into a solution of 0,1 g of $K[PtCl_3(C_2H_4)] \cdot H_2O$ in 20 ml of dried deoxygenated acetone and allowed to stand 24 h at room temperature. The polyacetylene film was thereafter transferred to another vessel, washed with fresh acetone and then dried under vacuum. The doped polyacetylene film thus obtained had an electrical conductivity of $8 \cdot 10^{-5} \Omega^{-1} \cdot cm^{-1}$.

### Example 11

A polyacetylene film was immersed into a solution of 0,1 g of $(COD)PdCl_2$ in 20 ml of dried deoxygenated methylene chloride and allowed to stand 24 h at room temperature. The polyacetylene film was thereafter transferred to another vessel, washed with fresh methylene chloride and then dried under vacuum. The doped polyacetylene film thus obtained had an electrical conductivity of $7 \cdot 10^{-6} \Omega^{-1} \cdot cm^{-1}$.

### Example 12

A polyacetylene film was immersed into a solution of 0,1 g of $(COD)PtCl_2$ in 20 ml of dried deoxygenated fresh methylene chloride and allowed to stand 24 h at room temperature, after which the polyacetylene film was taken out of the solution, washed with methylene chloride and then dried under vacuum. The doped polyacetylene film thus obtained had an electrical conductivity of $2 \cdot 10^{-5} \Omega^{-1} \cdot cm^{-1}$.

### Example 13

A polyacetylene film was immersed into a solution of 0,1 g of $(Ph_4C_4)PdCl_2$ in 20 ml of dried deoxygenated methylene chloride and allowed to stand 24 h at room temperature. The polyacetylene film was thereafter transferred to another vessel, washed with fresh methylene chloride and then dried under vacuum. The doped polyacetylene film thus obtained had an electrical conductivity of $3 \cdot 10^{-5} \Omega^{-1} \cdot cm^{-1}$.

### Example 14

A polyacetylene film was immersed into a solution of 0,1 g of $[Ph_3C]^+ClO_4^-$ in 20 ml of dried deoxygenated methylene chloride and allowed to stand 24 h at room temperature. The polyacetylene film was thereafter transferred to another vessel, washed with fresh methylene chloride and then dried under vacuum. The doped polyacetylene film thus obtained had an electrical conductivity of $3 \cdot 10^1 \Omega^{-1} \cdot cm^{-1}$.

### Example 15

Triphenylmethyl trifluoroacetate was synthesized by adding 0,5 g of $Ph_3COH$ to 3 ml of dried deoxygenated trifluoroacetic acid. A polyacetylene film was immersed into the resulting reaction mixture and allowed to stand 24 h at room temperature. The polyacetylene film was thereafter transferred to another vessel, washed with fresh trifluoroacetic acid and then dried under vacuum. The doped polyacetylene film thus obtained had an electrical conductivity of $3 \cdot 10^{-4} \Omega^{-1} \cdot cm^{-1}$.

For comparison, a polyacetylene film was immersed into 3 ml of deoxygenated trifluoroacetic acid and allowed to stand 24 h at room temperature. The polyacetylene film was thereafter taken out of the trifluoroacetic acid and then dried under vacuum. The polyacetylene film thus treated had an electrical conductivity of $<10^{-6} \Omega^{-1} \cdot cm^{-1}$.

## Claims

1. Polyacetylenes doped with a dopant, characterised by a dopant selected from platinum group metal complexes, carbonium salts, oxonium salts and parabenzoquinone compounds.

2. Doped polyacetylenes according to claim 1, characterised in that the dopant is a platinum group metal complex selected from

$(PhCN)_2PdCl_2$, $(COD)PdCl_2$, $[(C_2H_4)PdCl_2]_2$, $(Ph_4C_4)PdCl_2$, $(COD)PtCl_2$, $K[PtCl_3(C_2H_4)]H_2O$, $[Pt(C_2H_4)Cl_2]_2$, $(PhCN)_2PtCl_2$, $[(C_2H_4)_2RhCl]_2$ and $Ru(COD)Cl_2$,

wherein COD stands for 1,5-cyclooctadiene and $Ph_4C_4$ for tetraphenylcyclobutadiene.

5

3. Doped polyacetylenes according to claim 1, characterised in that the dopant is a palladium complex.

4. Doped polyacetylenes according to claim 3, characterised in that the dopant is $(PhCN)_2PdCl_2$ or $[(C_2H_4)PdCl_2]_2$.

5. Doped polyacetylenes according to claim 1, characterised in that the dopant is a combination of a cation selected from triphenylmethyl ion $[(C_6H_5)_3C]^+$, tropylium ion $[C_7H_7]^+$, acyl ion $[RCO]^+$, triethyloxonium ion $[(C_2H_5)_3O]^+$ and dialkoxycarbonium ion $[RC(OR')(OR'')]^+$ in which R, R' and R'' stand for organic groups, usually alkyls, aryls or aralkyls, with an anion selected from $BF_4^-$, $AlCl_4^-$, $FeCl_4^-$, $SnCl_5^-$, $PF_6^-$, $PCl_6^-$, $SbCl_6^-$, $SbF_6^-$, $ClO_4^-$, $CF_3SO_3^-$ and $CF_3CO_2^-$.

6. Doped polyacetylenes according to claim 1, characterised in that the dopant is a combination of a cation selected from the group consisting of triphenylmethyl ion $[(C_6H_5)_3C]^+$ and triethyloxonium ion $[(C_2H_5)_3O]^+$ with an anion selected from $BF_4^-$ and $ClO_4^-$.

7. Doped polyacetylenes according to claim 1, characterised in that the dopant is a parabenzoquinone compound selected from 2,3-dicyano-5-chloroparabenzoquinone, 2,3-dichloro-5,6-dicyano-parabenzoquinone, 2,3-dicyano-5-phenylsulfonylparabenzoquinone, 2,3-dicyano-5-chloro-6-phenylsulfonylparabenzoquinone and 2,3,5,6-tetracyanoparabenzoquinone.

8. Doped polyacetylenes according to claim 7, characterised in that the dopant is a parabenzoquinone compound having a first half wave reduction potential ($-E_{1/2}$) of less than $-0.2$ V as measured at 25°C by means of a saturated calomel electrode using $LiClO_4$ in acetonitrile as supporting electrolyte.

9. Doped polyacetylenes according to one of claims 1 to 8, characterised in that it is in the form of a film.

10. A process for producing the doped polyacetylenes according to one of claims 1 to 9 by immersing a polyacetylene under an inert gas atmosphere in an organic solvent solution of a dopant, characterised in that a dopant, selected from platinum group metal complexes, carbonium salts, oxonium salts and parabenzoquinone compounds is used.

11. A process according to claim 10, characterised in that the immersion is carried out at 10 to 70°C.

12. A process according to claim 10, characterised in that a platinum group metal complex selected from

$(PhCN)_2PdCl_2$, $(COD)PdCl_2$, $[(C_2H_4)PdCl_2]_2$, $(Ph_4C_4)PdCl_2$, $(COD)PtCl_2$, $K[PtCl_3(C_2H_4)]$—$H_2O$, $[Pt(C_2H_4)Cl_2]_2$, $(PhCN)_2PtCl_2$, $[(C_2H_4)_2RhCl]_2$ and $Ru(COD)Cl_2$,

wherein COD stands for 1,5-cyclooctadiene and $Ph_4C_4$ for tetraphenylcyclobutadiene is used as dopant.

13. A process according to claim 10, characterised in that a palladium complex is used as dopant.

14. A process according to claim 13, characterised in that $(PhCN)_2PdCl_2$ or $[(C_2H_4)PdCl_2]_2$ is used as dopant.

15. A process according to claim 10, characterised in that a combination of a cation selected from triphenylmethyl ion $[(C_6H_5)_3C]^+$, tropylium ion $[C_7H_7]^+$, acyl ion $[RCO]^+$, dialkoxycarbonium ion $[RC(OR')(OR'')]^+$, wherein R, R' and R'' may be the same or different and represent alkyls, aryls or aralkyls, and triethyloxonium ion $[(C_2H_5)_3O]^+$ with an anion selected from $BF_4^-$, $AlCl_4^-$, $FeCl_4^-$, $SnCl_5^-$, $PF_6^-$, $PCl_6^-$, $SbCl_6^-$, $SbF_6^-$, $ClO_4^-$, $CF_3SO_3^-$ and $CF_3CO_2^-$ is used as dopant.

16. A process according to claim 10, characterised in that a parabenzoquinone compound selected from 2,3-dicyano-5-chloroparabenzoquinone, 2,3-dichloro-5,6-dicyanoparabenzoquinone, 2,3-dicyano-5-phenylsulfonylparabenzoquinone, 2,3-dicyano-5-chloro-6-phenylsulfonylparabenzo-quinone and 2,3,5,6-tetracyanoparabenzoquinone is used as dopant.

17. A process according to claim 16, characterised in that a parabenzoquinone compound having a first half wave reduction potential ($-E_{1/2}$) of $<-0.2$ V as measured at 25°C by means of a saturated calomel electrode using $LiClO_4$ as a supporting electrolyte in acetonitrile is used as dopant.

18. A process according to claim 10, characterised in that an organic solvent selected from aromatic hydrocarbons, nitrile compounds, nitro compounds, ether compounds, lower alcohols, halogeno compounds, ester compounds, ketone compounds, sulfoxide compounds and lower organic acids and their anhydrides is used.

19. A process according to claim 10, characterised in that an organic solvent selected from benzene, toluene, xylene, nitromethane, nitroethane, nitrobenzene, acetonitrile, benzonitrile, diethyl ether, tetrahydrofuran, dioxane, anisole, methanol, ethanol, propanol, dichloromethane, chloroform, chlorobenzene, methylene chloride, trifluoroacetic acid, methyl acetate, ethyl acetate, acetone, acetophenone, dimethylsulfoxide, N,N-dimethylformamide, acetic acid and acetic anhydride is used.

20. Use of the doped polyacetylenes according to one of claims 1 to 9 for solar batteries and sensors.

**Patentansprüche**

1. Mit einem Dotierungsmittel dotierte Polyacetylene, gekennzeichnet durch ein unter Metallkomplexen vom Metallen der Platingruppe, Carbeniumulsalzen, Oxoniumsalzen und p-Benzochinonverbindungen ausgewähltes Dotierungsmittel.

2. Dotierte Polyacetylene nach Anspruch 1, dadurch gekennzeichnet, daß das Dotierungsmittel ein Metallkomplex eines Metalls der Platingruppe ist, der ausgewählt ist unter

$(PhCN)_2PdCl_2$, $(COD)PdCl_2$, $[(C_2H_4)PdCl_2]$, $(Ph_4C_4)PdCl_2$, $(COD)PtCl_2$, $K[PtCl_3(C_2H_4)]H_2O$, $[Pt(C_2H_4)Cl_2]_2$, $(PhCN)_2PtCl_2$, $[(C_2H_4)_2RhCl]_2$ und $Ru(COD)Cl_2$,

wobei COD 1.5-Cyclooctadien und $Ph_4C_4$ Tetraphenylcyclobutadien bedeuten.

3. Dotierte Polyacetylene nach Anspruch 1, dadurch gekennzeichnet, daß das Dotierungsmittel ein Palladiumkomplex ist.

4. Dotierte Polyacetylene nach Anspruch 3, dadurch gekennzeichnet, daß das Dotierungsmittel $(PhCN)_2PdCl_2$ oder $[(C_2H_4)PdCl_2]_2$ ist.

5. Dotierte Polyacetylene nach Anspruch 1, dadurch gekennzeichnet, daß das Dotierungsmittel eine Kombination eines unter Triphenylmethylium $[(C_6H_5)_3C]^+$, Tropylium $[C_7H_7]^+$, Acylkationen $[RCO]^+$, Triethyloxonium $[(C_2H_5)_3O]^+$ und Dialkoxycarbeniumionen $[RC(OR')(OR'')]^+$, wobei R, R' und R'' organische Gruppen, üblicherweise Alkylgruppen, Arylgruppen oder Aralkylgruppen bedeuten, ausgewählten Kations mit einem unter $BF_4^-$, $AlCl_4^-$, $FeCl_4^-$, $SnCl_5^-$, $PF_6^-$, $PCl_6^-$, $SbCl_6^-$, $SbF_6^-$, $ClO_4^-$, $CF_3SO_3^-$ und $CF_3CO_2^-$ ausgewählten Anion ist.

6. Dotierte Polyacetylene nach Anspruch 1, dadurch gekennzeichnet, daß das Dotierungsmittel eine Kombination eines unter Triphenylmethylium $[(C_6H_5)_3C]^+$ und Triethyloxonium $[(C_2H_5)_3O]^+$ ausgewählten Kations mit einem unter $BF_4^-$ und $ClO_4^-$ ausgewählten Anion ist.

7. Dotierte Polyacetylene nach Anspruch 1, dadurch gekennzeichnet, daß das Dotierungsmittel eine unter 2.3-Dicyano-5-chlor-p-benzochinon, 2.3-Dichlor-5.6-dicyano-p-benzochinon, 2.3-Dicyano-5-phenylsulfonyl-p-benzochinon, 2.3-Diano-5-chlor-6-phenylsulfonyl-p-benzochinon und 2.3.5.6-Tetracyano-p-benzochinon ausgewählte p-Benzochinonverbindung ist.

8. Dotierte Polyacetylene nach Anspruch 7, dadurch gekennzeichnet, daß das Dotierungsmittel eine p-Benzochinonverbindung mit einem ersten Halbstufen-Reduktionspotential $(-E_{1/2})$ $<-0,2$ V ist, gemessen bei 25°C mit einer gesättigten Kalomelelektrode unter Verwendung von $LiClO_4$ in Acetonitril als Trägerelektrolyt.

9. Dotierte Polyacetylene nach einem der Ansprüche 1 bis 8, dadurch gekennzeichnet, daß sie in Filmform vorliegen.

10. Verfahren zur Herstellung der dotierten Polyacetylene nach einem der Ansprüche 1 bis 9 durch Eintauchen eines Polyacetylens unter einer Inertgasatmosphäre in eine Lösung eines Dotierungsmittels in einem organischen Lösungsmittel, dadurch gekennzeichnet, daß ein unter Metallkomplexen von Metallen der Platingruppe, Carbeniumsalzen, Oxoniumsalzen und p-Benzochinonverbindungen ausgewähltes Dotierungsmittel verwendet wird.

11. Verfahren nach Anspruch 10, dadurch gekennzeichnet, daß das Eintauchen bei 10 bis 70°C vorgenommen wird.

12. Verfahren nach Anspruch 10, dadurch gekennzeichnet, daß ein Metallkomplex eines Metalls der Platingruppe, der unter

$(PhCN)_2PdCl_2$, $(COD)PdCl_2$, $[(C_2H_4)PdCl_2]_2$, $(Ph_4C_4)PdCl_2$, $(COD)PtCl_2$, $K[PtCl_3(C_2H_4)]—H_2O$, $[Pt(C_2H_4)Cl_2]_2$, $(PhCN)_2PtCl_2$, $[(C_2H_4)_2RhCl]_2$ und $Ru(COD)Cl_2$,

wobei COD 1.5-Cyclooctadien und $Ph_4C_4$ Tetraphenylcyclobutadien darstellen, ausgewählt ist, als Dotierungsmittel verwendet wird.

13. Verfahren nach Anspruch 10, dadurch gekennzeichnet, daß ein Palladiumkomplex als Dotierungsmittel verwendet wird.

14. Verfahren nach Anspruch 13, dadurch gekennzeichnet, daß $(PhCN)_2PdCl_2$ oder $[(C_2H_4)PdCl_2]_2$ als Dotierungsmittel verwendet werden.

15. Verfahren nach Anspruch 10, dadurch gekennzeichnet, daß eine Kombination eines unter Triphenylmethylium $[(C_6H_5)_3C]^+$, Tropylium $[C_7H_7]^+$, Acylkationen $[RCO]^+$, Dialkoxycarbeniumionen $[RC(OR')(OR'')]^+$, wobei R, R' und R'' gleich oder verschieden sind und Alkylgruppen, Arylgruppen oder Aralkylgruppen darstellen, und Triethyloxonium $[(C_2H_5)_3O]^+$ ausgewählten Kations mit einem unter $BF_4^-$, $AlCl_4^-$, $FeCl_4^-$, $SnCl_5^-$, $PF_6^-$, $PCl_6^-$, $SbCl_6^-$, $SbF_6^-$, $ClO_4^-$, $CF_3SO_3^-$ und $CF_3CO_2^-$ ausgewählten Anion als Dotierungsmittel verwendet wird.

16. Verfahren nach Anspruch 10, dadurch gekennzeichnet, daß eine unter 2.3-Dicyano-5-chlor-p-benzochinon, 2.3-Dichlor-5.6-dicyano-p-benzochinon, 2.3-Dicyano-5-phenylsulfonyl-p-benzochinon, 2.3-Dicyano-5-chlor-6-phenylsulfonyl-p-benzochinon und 2.3.5.6-Tetracyano-p-benzochinon ausgewählte p-Benzochinonverbindung als Dotierungsmittel verwendet wird.

17. Verfahren nach Anspruch 16, dadurch gekennzeichnet, daß eine p-Benzochinonverbindung mit einem ersten Halbstufen-Reduktionspotential $(-E_{1/2})$ $<-0,2$ V, gemessen bei 25°C mit einer gesättigten Kalomelelektrode unter Verwendung von $LiClO_4$ als Trägerelektrolyt in Acetonitril, als Dotierungsmittel verwendet wird.

18. Verfahren nach Anspruch 10, dadurch gekennzeichnet, daß ein unter aromatischen Kohlenwasserstoffen, Nitrilverbindungen, Nitroverbindungen, Etherverbindungen, niederen Alkoholen, Halogenverbindungen, Esterverbindungen, Ketonverbindungen, Sulfoxidverbindungen und niederen organischen Säuren und ihren Anhydriden ausgewähltes organisches Lösungsmittel verwendet wird.

19. Verfahren nach Anspruch 10, dadurch gekennzeichnet, daß ein unter Benzol, Toluol, Xylol, Nitromethan, Nitroethan, Nitrobenzol, Acetonitril, Benzonitril, Diethylether, Tetrahydrofuran, Dioxan, Anisol, Methanol, Ethanol, Propanol, Dichlormethan, Chloroform, Chlorbenzol, Methylenchlorid, Trifluoressigsäure, Methylacetat, Ethylacetat, Aceton, Acetophenon, Dimethylsulfoxid, N.N-Dimethylformamid, Essigsäure und Acetanhydrid ausgewähltes organisches Lösungsmittel verwendet wird.

20. Verwendung der dotierten Polyacetylene nach einem der Ansprüche 1 bis 9 für Solarbatterien und Sensoren.

**Revendications**

1. Polyacétylènes dopés avec un agent de dopage, caractérisés par un agent de dopage choisi par les complexes de métaux du groupe de platine, les sels carbénium, les sels oxonium et les composés parabenzoquinone.

2. Polyacétylènes dopés selon la revendication 1, caractérisés en ce que l'agent de dopage est un complexe d'un métal du groupe de platine, choisi par

$(PhCN)_2PdCl_2$, $(COD)PdCl_2$, $[(C_2H_4)PdCl_2]_2$, $(Ph_4C_4)PdCl_2$, $(COD)PtCl_2$,
$K[PtCl_3(C_2H_4)]H_2O$, $[Pt(C_2H_4)Cl_2]_2$, $(PhCN)_2PtCl_2$, $[(C_2H_4)_2RhCl]_2$ et $Ru(COD)Cl_2$,

COD représentant 1.5-cyclooctadiène et $Ph_4C_4$ tétraphénylcyclobutadiène.

3. Polyacétylènes dopés selon la revendication 1, caractérisés ence que l'agent de dopage est un complexe de palladium.

4. Polyacétylènes dopés selon la revendication 3, caractérisés en ce que l'agent de dopage est $(PhCN)_2PdCl_2$ ou $[(C_2H_4)PdCl_2]_2$.

5. Polyacétylènes dopés selon la revendication 1, caractérisés en ce que l'agent de dopage est une combinaison d'un cation choisi par triphénylméthylium $[(C_6H_5)_3C]^+$, tropylium $[C_7H_7]^+$, les cations acyle $[RCO]^+$, triéthyloxonium $[(C_2H_5)_3O]^+$ et les cations dialkoxycarbénium $[RC(OR')(OR'')]^+$, R, R' et R'' représentant des groupes organiques, usuellement des groupes alkyles, aryles ou aralkyles, avec un anion choisi par $BF_4^-$, $AlCl_4^-$, $FeCl_4^-$, $SnCl_5^-$, $PF_6^-$, $PCl_6^-$, $SbCl_6^-$, $SbF_6^-$, $ClO_4^-$, $CF_3SO_3$ et $CF_3CO_2^-$.

6. Polyacétylènes dopés selon la revendication 1, caractérisés en ce que l'agent de dopage est une combinaison d'un cation choisi par l'ion triphénylméthylium $[(C_6H_5)_3C]^+$ et l'ion triéthyloxonium $[(C_2H_5)_3O]^+$ avec un anion choisi par $BF_4^-$ et $ClO_4^-$.

7. Polyacetylènes dopés selon la revendication 1, caractérisés en ce que l'agent de dopage est un composé parabenzoquinone choisi par 2.3-dicyano-5-chloro-p-benzoquinone, 2.3-dichloro-5.6-dicyano-p-benzoquinone, 2.3-dicyano-5-phénylsulfonyle-p-benzoquinone, 2.3-dicyano-5-chloro-6-phénylsulfonyle-p-benzoquinone et 2.3.5.6-tétracyano-p-benzoquinone.

8. Polyacétylènes dopés selon la revendication 7, caractérisés en ce que l'agent de dopage est un composé parabenzoquinone ayant un premier potentiel de demi-vague $(-E_{1/2})$ $<-0,2$ V, mesuré à 25°C au moyen d'une électrode de calomel saturée en utilisant $LiClO_4$ dans l'acétonitrile comme électrolyte support.

9. Polyacétylènes dopés selon une des revendications 1 à 8, caractérisés en ce qu'ils se présentent sous forme d'un film.

10. Procédé de préparation des polyacétylènes selon l'une quelconque des revendications 1 à 9 par immersion d'un polyacétylène sous l'atmosphère d'un gaz inerte dans une solution d'un agent de dopage dans un solvant organique, caractérisé en ce qu'on utilise un agent de dopage choisi par les complexes de métaux du groupe de platine, les sels carbénium, les sels oxonium et les composés parabenzoquinone.

11. Procédé selon la revendication 10, caractérisé en ce que l'immersion est effectuée à 10 à 70°C.

12. Procédé selon la revendication 10, caractérisé en ce qu'on utilise un complexe d'un métal du groupe de platine choisi par

$(PhCN)_2PdCl_2$, $(COD)PdCl_2$, $[(C_2H_4)PdCl_2]_2$, $(Ph_4C_4)PdCl_2$, $(COD)PtCl_2$,
$K[PtCl_3(C_2H_4)]$—$H_2O$, $[Pt(C_2H_4)Cl_2]_2$, $(PhCN)_2PtCl_2$. $[(C_2H_4)_2RhCl]_2$ et $Ru(COD)Cl_2$,

COD représentant 1.5-cyclooctadiène et $Ph_4C_4$ représentant tétraphénylcyclobutadiène, comme agent de dopage.

13. Procédé selon la revendication 10, caractérisé en ce qu'on utilise un complexe de palladium comme agent de dopage.

14. Procédé selon la revendication 13, caractérisé en ce qu'on utilise $(PhCN)_2PdCl_2$ ou $[(C_2H_4)PdCl_2]_2$ comme agent de dopage.

15. Procédé selon la revendication 10, caractérisé en ce qu'on utilise une combinaison d'un cation choisi par triphénylméthylium $[(C_6H_5)_3C]^+$, tropylium $[C_7H_7]^+$, les cations acyle $[RCO]^+$, les cations dialkoxycarbénium $[RC(OR')(OR'')]^+$, R, R' et R'' étant identiques ou différents et représentant des groupes alkyles, aryles ou aralkyles, et triéthyloxonium $[(C_2H_5)_3O]^+$ avec un anion choisi par $BF_4^-$, $AlCl_4^-$, $FeCl_4^-$, $SnCl_5^-$, $PF_6^-$, $PCl_6^-$, $SbCl_6^-$, $SbF_6^-$, $ClO_4^-$, $CF_3SO_3^-$ et $CF_3CO_2^-$ comme agent de dopage.

16. Procédé selon la revendication 10, caractérisé en ce qu'on utilise un composé parabenzoquinone choisi par 2.3-dicyano-5-chloro-p-benzoquinone, 2.3-dichloro-5.6-dicyano-p-benzoquinone, 2.3-dicyano-5-chloro-6-phenylsulfonyle-p-benzoquinone et 2.3.5.6-tétracyano-p-benzoquinone comme agent de dopage.

17. Procédé selon la revendication 16, caractérisé en ce qu'on utilise un composé parabenzoquinone ayant un premier potentiel de demi-vague $(-E_{1/2}) < -0,2$ V, mesuré à 25°C au moyen d'une électrode de calomel saturée en utilisant $LiClO_4$ comme électrolyte support dans l'acétonitrile, comme agent de dopage.

18. Procédé selon la revendication 10, caractérisé en ce qu'on utilise un solvant organique choisi par les hydrocarbures aromatiques, les composés nitrile, les composés nitro, les composés éther, les alcools inférieurs, les composés halogénés, les composés ester, les composés ketone, les composés sulfoxide et les acides organiques inférieures et leurs anhydrides.

19. Procédé selon la revendication 10, caractérisé en ce qu'on utilise un solvant organique choisi par benzène, toluène, xylène, nitrométhane, nitroéthane, nitrobenzène, acétonitrile, benzonitrile, éther de diéthyle, tétrahydrofurane, dioxane, anisole, méthanol, éthanol, propanol, dichlorométhane, chloroforme, chlorobenzène, chlorure de méthylène, acide trifluoroacetique, acétate de méthyle, acétate d'éthyle, acétone, acétophénone, diméthyl sulfoxide, N.N.-diméthylformamide, acide acétique et l'anhydride de l'acide acétique.

20. Utilisation des polyacétylène dopés selon l'une quelconque des revendications 1 à 9 pour des batteries solaires et des détecteurs.